# EUROPÄISCHE PATENTSCHRIFT

(11) **EP 0 732 557 B1**
(45) Veröffentlichungstag und Bekanntmachung des Hinweises auf die Patenterteilung: **24.01.2001**
(21) Anmeldenummer: 96102468.4
(22) Anmeldetag: 19.02.1996
(51) Int. Cl.: F26B 5/00, H01L 21/306

(54) **Verfahren zum Trocknen mikromechanischer Komponenten**
Process for drying micro-mechanical devices
Procédé pour le séchage de componants micromécaniques

(30) Priorität: 23.02.1995 DE 19506404
(43) Veröffentlichungstag der Anmeldung: 18.09.1996
(73) Patentinhaber: Infineon Technologies AG, 81541 München (DE)
(72) Erfinder: Biebl, Markus, D-86163 Ausburg (DE)
(74) Vertreter: Zedlitz, Peter, Dipl.-Inf.

(56) Entgegenhaltungen:
- EP-A- 0 403 962
- EP-A- 0 631 190
- WO-A-90/09677
- FR-A- 2 218 020
- PATENT ABSTRACTS OF JAPAN vol. 18, no. 545 (E-1617), 18.Oktober 1994 & JP 06 196472 A (SOLTEC:KK), 15.Juli 1994,

## Beschreibung

Mikromechanische Komponenten, wie z. B. bewegliche mikromechanische Teile von Sensoren und Aktuatoren, werden bei der Herstellung üblicherweise naßchemisch freigeätzt, um sie von dem restlichen Teil des Bauelementes zu separieren. Die Ätzflüssigkeit muß anschließend entfernt werden. Das geschieht zunächst dadurch, daß die Ätzflüssigkeit mit einer anderen Flüssigkeit von dem Bauelement abgespült wird. Diese Spülflüssigkeit muß anschließend durch Trocknen entfernt werden. Dabei tritt das Problem auf, daß beim allmählichen Wegtrocknen dieser Flüssigkeit sich das mikromechanische Teil der festen Oberfläche annähert und schließlich darauf klebenbleibt. Außerdem können in der Spülflüssigkeit Turbulenzen auftreten, die das empfindliche mikromechanische Teil auslenken und ebenfalls zu einem Klebenbleiben (Sticking) führen. Es wurden daher für die Herstellung bisher Verfahren verwendet, bei denen die Bauelemente nacheinander in verschiedenen Behältern (Rezipienten) bearbeitet werden. Um nach dem Ätzen, was z. B. mit Flußsäure (HF) geschieht, zu verhindern, daß die wäßrige Flüssigkeit von der wasserabstoßenden Oberfläche des Bauelementes sofort abläuft und damit ein sofortiges Klebenbleiben der beweglichen Komponente hervorgerufen würde, muß in dem ersten Schritt des Verfahrens eine benetzende Flüssigkeit zugegeben werden. Es sind bei dem Verfahren eine Vielzahl von einzelnen Verfahrensschritten erforderlich, in denen das Bauelement jeweils von einem Rezipienten in den nächsten gebracht wird und verschiedene Flüssigkeiten eingesetzt werden. Jeder dieser Übergänge ist mit der Bildung von Turbulenzen in den jeweils auf dem Bauelement befindlichen Flüssigkeiten verbunden, die jeweils das Risiko in sich bergen, daß die bewegliche Komponente auf dem Bauelement klebenbleibt. Die zuletzt aufgebrachte Flüssigkeit wird abgetrocknet, indem diese Flüssigkeit vollständig in den gasförmigen Aggregatzustand (Phase) überführt wird. Das kann durch einen direkten Phasenübergang vom flüssigen in den gasförmigen Aggregatzustand erfolgen, oder es wird die Flüssigkeit zum Erstarren gebracht und anschließend durch Sublimation der feste in den gasförmigen Aggregatzustand unmittelbar überführt.

Oberhalb der sogenannten kritischen Temperatur kann man ein Gas nicht mehr durch eine Erhöhung des Druckes verflüssigen. Ein homogen zusammengesetzter chemischer Stoff befindet sich also oberhalb dieser kritischen Temperatur vollständig im gasförmigen Aggregatzustand (Phase). Eine vollständige Trocknung, d. h. ein vollständiges Verdampfen einer Flüssigkeit, läßt sich also dadurch erreichen, daß nur die Temperatur unabhängig von dem herrschenden Druck über die kritische Temperatur erhöht wird. In dem Volumen-Druck-Phasendiagramm (pV-Diagramm) ist in der mit der Temperatur parametrisierten Kurvenschar eine dieser Isothermen als Grenze desjenigen Bereiches ausgezeichnet, in dem bei fester Temperatur keine Verflüssigung durch Erhöhung des Druckes erfolgen kann. Die Flüssigkeit kann also vollständig abgetrocknet werden, indem die Temperatur über den diese Isotherme festlegenden Wert erhöht wird. Weil diese Isotherme durch den sogenannten "kritischen Punkt" verläuft, wird dieses Trocknungsverfahren auch als Kritischer-Punkt-Trocknen bezeichnet. Bei der Trocknung durch Sublimation (Überführen aus der festen in die gasförmige Phase) einer Chemikalie wird die Flüssigkeit, die sich auf dem Bauelement befindet, zunächst durch Senken der Temperatur zum Erstarren gebracht, und anschließend wird der Druck soweit verringert, daß ggf. bei gleichzeitiger Temperaturerhöhung die feste Chemikalie zu einem Gas sublimiert. Bei den beschriebenen Verfahren können jeweils nur einzelne Chips, aber keine ganzen Halbleiterscheiben mit einer Vielzahl von Bauelementen bearbeitet werden.

In dem nächstliegenden Stand der Technik gemäß der JP-A-06 196 472 ist ein Verfahren zum Naßätzen beschrieben, bei dem Polysiliziumstrukturen auf einem Si-Substrat ausgebildet werden und eine mit einer Lackmaske versehene SiO₂-Schicht mit wässriger HF-Lösung geätzt wird. Nach dem Spülen der Substratoberfläche mit Wasser wird die Spülflüssigkeit durch Propanol-2 ersetzt. Die Probe wird gekühlt und in ein mit Trockeneis gefülltes Gefäß gebracht, in dem unter Erwärmung und Druckerhöhung das Propanol-2 durch flüssiges CO₂ ersetzt wird. Das Gefäß wird über die kritische Temperatur von CO₂ erwärmt, so daß das CO₂ als Gas entweicht und die Probe getrocknet wird.

Aufgabe der vorliegenden Erfindung ist es, ein Verfahren zum Separieren und Trocknen naßchemisch geätzter mikromechanischer Komponenten anzugeben, bei dem das Problem des Klebenbleibens (Sticking) nicht auftritt.

Diese Aufgabe wird mit den Verfahren mit den Merkmalen des Anspruches 1 bzw. 2 gelöst. Weitere Ausgestaltungen ergeben sich aus den abhängigen Ansprüchen.

Bei den erfindungsgemäßen Verfahren erfolgen sowohl das Ätzen zum Strukturieren und Separieren der mikromechanischen Komponente als auch die Dehydrierung und die Trocknung in demselben Rezipienten (Behälter). Auf diese Weise kann eine Bildung von Turbulenzen, wie sie beim Wechsel der Behälter zu erwarten sind, vermieden werden. Bei den erfindungsgemäßen Verfahren werden solche Turbulenzen dadurch vermieden, daß nacheinander Flüssigkeiten mit geringerer Dichte als die der jeweils vorhergehenden Flüssigkeit eingesetzt werden. Diese Flüssigkeiten werden von oben in den Rezipienten eingelassen, so daß die zuvor in dem Rezipienten befindliche Flüssigkeit mit größerer Dichte ohne Wirbelbildung nach unten aus dem Rezipienten abgelassen werden kann.

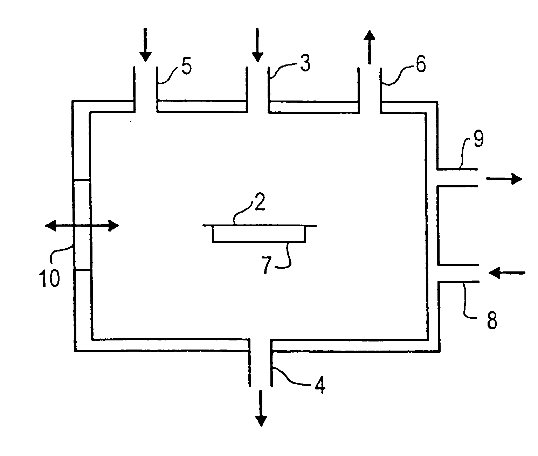

In der beigefügten Figur ist ein für die Verfahren geeigneter Rezipient im Schema dargestellt. Im Inneren des Rezipienten 1 befindet sich das zu trocknende Bauelement 2, für das ggf. eine Heizung oder ein Kühlaggregat 7 vorgesehen sein kann. In der Wand des Rezipienten befindet sich die Schleuse 10 für die Beschickung des Rezipienten mit den zu bearbeitenden Chips oder Wafern. In der oberen Wand des Rezipienten befinden sich Öffnungen für das Einlassen einer Flüssigkeit (Flüssigkeitseinlaß 3), für das Einlassen eines verflüssigten Gases (Flüssiggaseinlaß 5) und eine Gasauslaßöffnung 6. In der Wand befindet sich ein Volumen, das mit einer Flüssigkeit durchspült (z. B. Wasser) als Heizung oder als Kühlung eingesetzt werden kann. Eine dafür vorgesehene Einlaßöffnung 8 und eine Auslaßöffnung 9 befinden sich in diesem Beispiel an der Seitenwand. Auf der Unterseite befindet sich eine Öffnung zum Ablassen von Flüssigkeiten (Flüssigkeitsauslaß 4).

Das zu bearbeitende Bauelement mit einer für eine mikromechanische Komponente vorgesehenen Beschichtung wird durch die Schleuse 10 ins Innere des Rezipienten gebracht. Die Schleuse wird geschlossen, und durch den Flüssigkeitseinlaß 3 wird ein flüssiges Ätzmittel, z. B. eine fluorwasserstoffhaltige wäßrige Lösung (Flußsäure, HF), eingelassen. Damit wird naßchemisch die vorgesehene Strukturierung der mikromechanischen Komponente vorgenommen. Die Ätzflüssigkeit, in diesem Beispiel also HF in wässriger Lösung, wird dann nach unten durch den Flüssigkeitsauslaß 4 abgelassen. Gleichzeitig wird durch den Flüssigkeitseinlaß 3 z. B. deionisiertes Wasser eingelassen, was die Ätzchemikalie nach unten hin verdrängt. Wasser hat eine geringere Dichte als die für das Ätzen verwendete Fluorwasserstoffsäure.

Im allgemeinen Fall wird als Spülflüssigkeit bei diesem Verfahren eine Flüssigkeit verwendet, die bei der eingestellten Temperatur eine geringere Dichte aufweist als die für das Ätzen verwendete Flüssigkeit. Auf diese Weise wird erreicht, daß bei dem gleichzeitigen Auslassen der zu ersetzenden Flüssigkeit und dem Einlassen der ersetzenden Flüssigkeit sich im Inneren des Rezipienten stets eine Schichtung der Flüssigkeit befindet, in der unten die dichtere und oben die weniger dichte Flüssigkeit vorhanden ist. Bei ausreichendem Dichteunterschied können Wirbelbildungen, also Turbulenzen in der Flüssigkeit verhindert werden, so daß die zuvor in dem Rezipienten befindliche Flüssigkeit nach unten in einer im wesentlichen laminaren Strömung abfließen kann. Das freigeätzte mikromechanische Teil wird dann nicht oder kaum ausgelenkt, so daß es nicht mit dem Rest des Bauelementes in Kontakt kommt.

Die mikromechanische Komponente wird mit dieser eingelassenen Flüssigkeit, in diesem Beispiel deionisiertes Wasser, gespült, um das Ätzmittel vollständig zu entfernen. Anschließend wird eine Flüssigkeit, die eine geringere Dichte als Wasser hat, durch den Flüssigkeitseinlaß 3 in den Rezipienten eingelassen. Es kann dafür z. B. Ethanol (Dichte 789 kg/m³ bei 20°C) oder Aceton (Dichte 791 kg/m³ bei 20°C) verwendet werden. Diese Flüssigkeiten können ggf. durch weitere Flüssigkeiten mit jeweils abnehmender Dichte ersetzt werden. Wenn bei Temperaturen wesentlich unter 0°C gearbeitet wird, kann Ethanol auch durch Aceton ersetzt werden, das bei sehr niedrigen Temperaturen eine geringere Dichte als Ethanol aufweist. Anstelle von Ethanol kann z. B. ein anderer Alkohol, wie z. B. Methanol, verwendet werden.

Zuletzt wird eine Flüssigkeit eingelassen, die dafür vorgesehen ist, durch eine Erhöhung der Temperatur vollständig verdampft zu werden, das heißt von dem flüssigen in den gasförmigen Aggregatzustand überführt zu werden. Dafür kann z. B. flüssiges Kohlendioxid verwendet werden, das z. B. aus einer an den Flüssiggaseinlaß 5 angeschlossenen Gasflasche in den Rezipienten eingelassen wird. Die zuvor in den Rezipienten eingelassene Flüssigkeit wird so gewählt, daß sie eine größere Dichte hat als das zuletzt eingelassene verflüssigte Gas. Im Fall flüssigen Kohlendioxids kann die zuvor verwendete Flüssigkeit z. B. wie angegeben Ethanol oder Aceton sein. Nachdem sämtliche Öffnungen des Rezipienten verschlossen worden sind, wird das flüssige Kohlendioxid durch eine Temperaturerhöhung über die kritische Temperatur hinaus erwärmt. Diese Aufheizung kann z. B. mit heißem Wasser erfolgen, das über die Einlaßöffnung 8 und die Auslaßöffnung 9 durch das in der Wand des Rezipienten befindliche Volumen geleitet wird. Die kritische Temperatur von Kohlendioxid liegt bei 30,98°C. Wenn die Temperatur des Kohlendioxids oberhalb dieses Wertes liegt, ist das Kohlendioxid schließlich vollständig verdampft, d. h. nur noch in der gasförmigen Phase vorhanden. Die Gasauslaßöffnung 6 kann dann geöffnet werden, um den Druck im Innern des Rezipienten langsam auf den umgebenden Luftdruck zu senken. Die Schleuse 10 wird geöffnet und das getrocknete Bauelement aus dem Rezipienten genommen.

Statt des Kohlendioxids kann ein anderes Gas verwendet werden, das im Rahmen der für das Verfahren vorgesehenen Bedingungen (erreichbarer Druck und erreichbare Temperatur) als Flüssigkeit eingelassen und über den kritischen Punkt hinaus erwärmt werden kann. Verwendbar ist z. B. eine Halogen-Kohlenstoff-Verbindung (z. B. ein Freon). Die kritische Temperatur von CClF₃ liegt bei 29°C, so daß dieses Freon z. B. sehr gut anstelle von Kohlendioxid verwendet werden kann.

Als Alternative zur Trocknung durch unmittelbare Überführung der zuletzt verwendeten Flüssigkeit aus dem flüssigen in den gasförmigen Aggregatzustand kann die Flüssigkeit auch zunächst zum Erstarren gebracht werden und dann aus dem festen direkt in den gasförmigen Aggregatzustand gebracht werden. Im Rahmen der erfindungsgemäßen Verfahren mögliche alternative Trocknungsprozesse können ggf. abwechselnd in demselben Rezipienten erfolgen. Bei Trocknung durch Sublimation wird vorzugsweise zuletzt eine geschmolzene Chemikalie, d. h. ein chemischer Stoff, der bei Normalbedingungen fest ist, eingelassen. Dabei wird der Rezipient z. B. unter Verwendung der eingebauten Wasserheizung auf einer gegenüber der Umgebungstemperatur erhöhten Temperatur gehalten, damit diese Chemikalie im flüssigen Aggregatzustand bleibt. Es läßt sich bei geeigneter Wahl dieser Chemikalie dann mit einer vergleichsweise geringen Temperatursenkung erreichen, daß die Chemikalie erstarrt, so daß die zu trocknende mikromechanische Komponente von einem chemischen Stoff im festen Aggregatzustand umgeben ist. Der Phasenübergang vom festen in den gasförmigen Aggregatzustand (Sublimation) läßt sich dadurch erreichen, daß der Druck in dem Rezipienten ausreichend gesenkt wird. Zu dem Zweck kann z. B. eine Vakuumpumpe an die Gasauslaßöffnung 6 des Rezipienten angeschlossen werden. Der Druck muß soweit gesenkt werden, daß der Phasenübergang von der festen in die gasförmige Phase direkt erfolgt. Wenn der Druck ausreichend niedrig ist, kann dieser Phasenübergang durch eine zusätzliche Temperaturerhöhung unterstützt werden. Wenn der feste chemische Stoff vollständig sublimiert ist, d. h. in den gasförmigen Aggregatzustand übergegangen ist und durch die Gasauslaßöffnung 6 abgepumpt wurde, kann der in dem Rezipienten herrschende Druck an den äußeren Luftdruck angepaßt werden. Es ist dann möglich, das bearbeitete Bauelement durch die Schleuse 10 aus dem Rezipienten zu entnehmen. Für die zu sublimierende Chemikalie kommen z. B. Dichlorbenzol, Tert-Butanol und Cyclohexan oder auch ein Wasser-Alkohol-Gemisch in Frage. Die Temperaturen und Drücke sind an die physikalischen Eigenschaften des jeweils verwendeten chemischen Stoffes anzupassen. Für diesen zuletzt beschriebenen alternativen Verfahrensschritt erscheinen alle chemischen Stoffe als besonders geeignet, deren Schmelzpunkt in der Nähe der Raumtemperatur liegt und die sich bei mäßiger Druckverminderung sublimieren lassen.

Bei den Verfahren können mikromechanische Komponenten auf Bauelementen auch auf Scheibenebene, d. h. wenn sich die Bauelemente noch auf einem Halbleiterwafer befinden, mit hoher Ausbeute an brauchbaren Bauelementen freigeätzt und getrocknet werden. Bei langsamem Austausch der verschiedenen Flüssigkeiten fallender Dichte können Turbulenzen soweit vermieden werden, daß die Strömung in der Flüssigkeit ausreichend laminar bleibt, um Auslenkungen der beweglichen Teile und damit ein Sticking zu vermeiden. Außerdem sind die Verfahren weitgehend automatisierbar, was die Zuverlässigkeit erhöht, die Kosten senkt und eine sehr gut reproduzierbare Durchführbarkeit gewährleistet. Die Verfahren können daher im großen Maßstab für industrielle Produktion eingesetzt werden.

## Patentansprüche

1. Verfahren zur Trocknung mikromechanischer Funktionselemente auf einem Halbleiterbauelement, bei dem
a) ein zu bearbeitendes Bauelement mit einer für eine mikromechanische Komponente vorgesehenen Beschichtung ins Innere eines Rezipienten gebracht wird und die vorgesehene Strukturierung der mikromechanischen Komponente naßchemisch freigeätzt wird,
b) eine dazu verwendete flüssige Ätzchemikalie aus dem Rezipienten abgelassen und eine Flüssigkeit als Spülmittel in den Rezipienten eingelassen wird, die die Ätzchemikalie nach unten verdrängt,
c) die in dem vorhergehenden Schritt b) eingelassene Flüssigkeit aus dem Rezipienten abgelassen und eine Flüssigkeit mit einer geringeren Dichte als das Spülmittel in den Rezipienten eingelassen wird,
d) Schritt c) nach Bedarf wiederholt wird, indem weitere Flüssigkeiten mit jeweils abnehmender Dichte ersetzt werden,
e) durch eine Änderung des Druckes oder/und der Temperatur im Innern des Rezipienten die zuletzt eingelassene Flüssigkeit vollständig in den gasförmigen Aggregatzustand überführt wird und
f) der Druck in dem Rezipienten an einen äußeren Luftdruck angeglichen wird und das behandelte Bauelement aus dem Rezipienten entnommen wird.

2. Verfahren zur Trocknung mikromechanischer Funktionselemente auf einem Halbleiterbauelement, bei dem
a) ein zu bearbeitendes Bauelement mit einer für eine mikromechanische Komponente vorgesehenen Beschichtung ins Innere eines Rezipienten gebracht wird und die vorgesehene Strukturierung der mikromechanischen Komponente naßchemisch freigeätzt wird,
b) eine dazu verwendete flüssige Ätzchemikalie aus dem Rezipienten abgelassen und eine Flüssigkeit als Spülmittel in den Rezipienten eingelassen wird, die die Ätzchemikalie nach unten verdrängt,
c) die in dem vorhergehenden Schritt b) eingelassene Flüssigkeit aus dem Rezipienten abgelassen und eine Flüssigkeit mit einer geringeren Dichte als das Spülmittel in den Rezipienten eingelassen wird,
d) Schritt c) nach Bedarf wiederholt wird, indem weitere Flüssigkeiten mit jeweils abnehmender Dichte ersetzt werden, und für die zuletzt eingelassene Flüssigkeit ein chemischer Stoff verwendet wird, der sich durch eine Änderung des Druckes oder/und der Temperatur aus dem festen Aggregatzustand in den gasförmigen Aggregatzustand sublimieren läßt,
e) diese Flüssigkeit durch Senken der Temperatur oder/und Erhöhung des Druckes in dem Rezipienten in den festen Aggregatzustand überführt wird und dann dieser erstarrte chemische Stoff durch Verringern des in dem Rezipienten herrschenden Druckes oder/und Erhöhen der Temperatur in dem Rezipienten vollständig in den gasförmigen Aggregatzustand sublimiert wird und
f) der Druck in dem Rezipienten an einen äußeren Luftdruck angeglichen wird und das behandelte Bauelement aus dem Rezipienten entnommen wird.

3. Verfahren nach Anspruch 2, bei dem
für die zuletzt eingelassene Flüssigkeit flüssiges Dichlorbenzol verwendet wird.

4. Verfahren nach Anspruch 2, bei dem
für die zuletzt eingelassene Flüssigkeit flüssiges Cyclohexan verwendet wird.

5. Verfahren nach Anspruch 2, bei dem
für die zuletzt eingelassene Flüssigkeit ein flüssiger Alkohol oder ein flüssiges Gemisch von Wasser mit Alkohol verwendet wird.

6. Verfahren nach einem der Ansprüche 1 bis 5, bei dem
in Schritt b als Spülmittel deionisiertes Wasser eingelassen wird.

7. Verfahren nach einem der Ansprüche 1 bis 6, bei dem
in den Schritten c oder d Ethanol oder Aceton verwendet wird.

8. Verfahren nach einem der Ansprüche 1, 6 und 7, bei dem
für die zuletzt eingelassene Flüssigkeit flüssiges Kohlendioxid verwendet wird.

9. Verfahren nach einem der Ansprüche 1, 6 und 7, bei dem
für die zuletzt eingelassene Flüssigkeit eine flüssige Halogenverbindung verwendet wird.

10. Verfahren nach Anspruch 9, bei dem
für die zuletzt eingelassene Flüssigkeit eine flüssige Fluorverbindung verwendet wird.

## Claims

1. Process for drying micromechanical functional elements on a semiconductor component, in which
a) a component which is to be processed and has a coating provided for a micromechanical component is introduced into the interior of a receptacle and in the intended structuring of the micromechanical component is etched clear by wet chemical means,
b) a liquid etching chemical used for this purpose is drained out of the receptacle and a liquid is admitted to the receptacle as a rinsing agent, displacing the etching chemical downwards,
c) the liquid which was admitted in the previous step b) is drained out of the receptacle, and a liquid with a lower density than the rinsing agent is admitted to the receptacle,
d) step c) is repeated as required, in that further liquids of increasingly low density are replaced,
e) the liquid which was admitted last is completely converted into the gaseous state of aggregation as a result of the pressure and/or temperature in the interior of the receptacle being changed, and
f) the pressure in the receptacle is matched to an external air pressure, and the treated component is removed from the receptacle.

2. Process for drying micromechanical functional elements on a semiconductor component, in which
a) a component which is to be processed and has a coating provided for a micromechanical component is introduced into the interior of a receptacle and in the intended structuring of the micromechanical component is etched clear by wet chemical means,
b) a liquid etching chemical used for this purpose is drained out of the receptacle and a liquid is admitted to the receptacle as a rinsing agent, displacing the etching chemical downwards,
c) the liquid which was admitted in the previous step b) is drained out of the receptacle, and a liquid with a lower density than the rinsing agent is admitted to the receptacle,
d) step c) is repeated as required, in that further liquids of increasingly low density are replaced, and a chemical substance which can be sublimed from the solid state of aggregation into the gaseous state of aggregation as a result of the pressure and/or the temperature being changed is used for the liquid admitted last,
e) this liquid is converted into the solid state of aggregation as a result of the temperature in the receptacle being reduced and/or the pressure in the receptacle being increased, and then this solidified chemical substance is sublimed completely into the gaseous state of aggregation as a result of the pressure prevailing in the receptacle being reduced and/or the temperature in the receptacle being increased, and
f) the pressure in the receptacle is matched to an external air pressure, and the treated component is removed from the receptacle.

3. Process according to Claim 2, in which liquid dichlorobenzene is used for the liquid admitted last.

4. Process according to Claim 2, in which liquid cyclohexane is used for the liquid admitted last.

5. Process according to Claim 2, in which a liquid alcohol or a liquid mixture of water and alcohol is used for the liquid admitted last.

6. Process according to one of Claims 1 to 5, in which in step b) the rinsing agent admitted is deionized water.

7. Process according to one of Claims 1 to 6, in which ethanol or acetone is used in steps c) or d).

8. Method according to one of Claims 1, 6 and 7, in which liquid carbon dioxide is used for the liquid admitted last.

9. Process according to one of Claims 1, 6 and 7, in which a liquid halogen compound is used for the liquid admitted last.

10. Process according to Claim 9, in which a liquid fluorine compound is used for the liquid admitted last.

## Revendications

1. Procédé pour sécher des éléments de fonction micromécaniques sur un composant semi-conducteur au cours duquel
a) un composant à traiter, comportant une couche prévue pour un constituant micromécanique, est placé à l'intérieur d'un récipient et la structuration prévue du constituant micromécanique est dégagée par lavage chimique,
b) on fait s'écouler du récipient un produit chimique corrosif liquide utilisé à cet effet et on introduit dans le récipient un liquide, utilisé comme moyen de rinçage, qui repousse vers le bas le produit chimique corrosif,
c) on fait s'écouler du récipient le liquide introduit au cours de l'étape b) précédente et on introduit dans le récipient un liquide ayant une densité inférieure au moyen de rinçage,
d) l'étape c) est, si nécessaire, répétée en remplaçant d'autres liquides ayant chacun une densité décroissante,
e) grâce à une modification de la pression et/ou de la température à l'intérieur du récipient, on fait entièrement passer le liquide introduit en dernier à l'état gazeux et
f) la pression dans le récipient est harmonisée à une pression de l'air extérieure et le composant traité est extrait du récipient.

2. Procédé pour sécher des éléments de fonction micromécaniques sur un composant semi-conducteur au cours duquel
a) un composant à traiter, comportant une couche prévue pour un constituant micromécanique, est placé à l'intérieur d'un récipient et la structuration prévue du constituant micromécanique est dégagée par lavage chimique,
b) on fait s'écouler du récipient un produit chimique corrosif liquide utilisé à cet effet et on introduit dans le récipient un liquide, utilisé comme moyen de rinçage, qui repousse vers le bas le produit chimique corrosif,
c) on fait s'écouler du récipient le liquide introduit au cours de l'étape b) précédente et on introduit dans le récipient un liquide ayant une densité inférieure au moyen de rinçage,
d) l'étape c) est, si nécessaire, répétée en remplaçant d'autres liquides ayant chacun une densité décroissante et on utilise, comme liquide introduit en dernier, un produit chimique que l'on peut faire sublimer, par modification de la pression et/ou de la température, de son état solide en son état gazeux,
e) on fait passer ce liquide dans son état solide grâce à une baisse de la température et/ou une augmentation de la pression dans le récipient et, ensuite, on fait entièrement passer ce produit chimique solidifié dans son état gazeux, en diminuant la pression existant dans le récipient et/ou en augmentant la température et
f) la pression dans le récipient est harmonisée à une pression de l'air extérieure et le composant traité est extrait du récipient.

3. Procédé selon la revendication 2 au cours duquel
on utilise du dichlorobenzène comme liquide introduit en dernier.

4. Procédé selon la revendication 2 au cours duquel
on utilise du cyclohexane comme liquide introduit en dernier.

5. Procédé selon la revendication 2 au cours duquel
on utilise un alcool liquide ou un mélange liquide d'eau et d'alcool comme liquide introduit en dernier.

6. Procédé selon l'une des revendications 1 à 5 au cours duquel
on introduit de l'eau désionisée en tant que moyen de rinçage pour l'étape b).

7. Procédé selon l'une des revendications 1 à 6 au cours duquel
on utilise de l'éthanol ou de l'acétone pour les étapes c) ou d).

8. Procédé selon l'une des revendications 1, 6 et 7 au cours duquel
on utilise du dioxyde de carbone liquide en tant que liquide introduit en dernier.

9. Procédé selon l'une des revendications 1, 6 et 7 au cours duquel
on utilise une combinaison liquide d'halogène en tant que liquide introduit en dernier.

10. Procédé selon la revendication 9 au cours duquel
on utilise une combinaison liquide de fluor en tant que liquide introduit en dernier.
